# EUROPEAN PATENT SPECIFICATION

(11) **EP 3 310 136 B1**
(45) Date of publication and mention of the grant of the patent: **26.04.2023**
(21) Application number: 15895025.3
(22) Date of filing: 11.06.2015
(51) Int. Cl.: H05K 3/28, C09D 5/00, C08J 9/00, H01L 51/52, C09D 7/61, B32B 27/06, C08J 5/18

(54) **COMPOSITION FOR MOISTURE PERMEATION PREVENTING FILM FOR ELECTRONIC DEVICE, METHOD FOR FORMING MOISTURE PERMEATION PREVENTING FILM FOR ELECTRONIC DEVICE USING SAME, AND ELECTRONIC DEVICE**
ZUSAMMENSETZUNG FÜR EINE FEUCHTIGKEITSPERMEATIONSVERHINDERUNGSFOLIE FÜR EINE ELEKTRONISCHE VORRICHTUNG, VERFAHREN ZUR HERSTELLUNG EINER FEUCHTIGKEITSPERMEATIONSVERHINDERUNGSFOLIE FÜR EINE ELEKTRONISCHE VORRICHTUNG DAMIT UND ELEKTRONISCHE VORRICHTUNG
COMPOSITION POUR FILM DE PROTECTION CONTRE L'IMPRÉGNATION DE L'HUMIDITÉ POUR DISPOSITIF ÉLECTRONIQUE, PROCÉDÉ DE FORMATION DE FILM DE PROTECTION CONTRE L'IMPRÉGNATION DE L'HUMIDITÉ POUR DISPOSITIF ÉLECTRONIQUE UTILISANT CELUI-CI, ET DISPOSITIF ÉLECTRONIQUE

(43) Date of publication of application: 18.04.2018
(73) Proprietor: Aerogel R&D Pte. Ltd., Singapore 059413 (SG)
(72) Inventor: ROH, Myung Je, Seoul 140-748 (KR); JOUNG, Young Chul, Gyeonggi-do 445-160 (KR); PARK, Jong Chul, Gyeonggi-do 447-746 (KR); KIM, Min Woo, Daejeon 301-774 (KR); HAHN, Choon Soo, Jeollabuk-do 595-881 (KR); LEE, Mun Hyeong, Chungcheongnam-do 330-746 (KR); JUNG, Dong Ho, Gyeonggi-do 447-140 (KR); PARK, Do Young, Gyeonggi-do 443-738 (KR)
(74) Representative: Dentons UK and Middle East LLP
(86) International application number: PCT/KR2015/005885
(87) International publication number: WO 2016/199957

(56) References cited:
- WO-A2-2005/047746
- JP-A- 2000 043 179
- KR-A- 20140 135 394
- KR-B1- 101 288 736
- KR-B1- 101 460 242
- KR-U- 20090 010 907
- US-A1- 2005 027 027

## Description

### [Technical Field]

The present invention relates to a composition for a moisture permeation preventing film for an electronic device, a method for forming a moisture permeation preventing film for an electronic device using the same, and an electronic device.

### [Background Art]

In general, glass materials are mainly used as the material for a moisture permeation preventing film for an electronic device when flexibility is not required, and when flexibility is required, film or ink materials are used.

Meanwhile, regardless of the material, moisture permeation preventing films are generally formed in a multilayer structure in order to secure low moisture permeability which is the unique function of a moisture permeation preventing film for an electronic device. WO2005/047746 describes a curable coating composition for forming a thermal insulating layer. JP2000043179 describes a humidity controlling layer containing mesoporous silica on a plastic sheet. KR101288736 relates to an aerogel paste and a manufacturing method of the same are provided to coat the surfaces of various materials including films.

However, in the case of moisture permeation preventing films manufactured by using glass materials or moisture permeation preventing films formed in a multilayer structure, flexibility is insufficiently low, the manufacturing process thereof is complex, and, as a result, problems of low productivity and price competitiveness happen due to increased manufacturing costs.

### [Detailed Description]

### [Technical Problem]

The present inventors attempt to solve the problems described above by disclosing a composition for a moisture permeation preventing film for an electronic device including an aerogel.

Moreover, a method for forming a moisture permeation preventing film for an electronic device in a simple process using the composition is disclosed, and in addition, an electronic device including the moisture permeation preventing film is disclosed.

### [Technical Solution]

In one embodiment of the present invention, provided is a composition for a moisture permeation preventing film for an electronic device, comprising:
1 to 10 wt% of an aerogel that comprises silica;
10 to 50 wt% of a solvent;
0.1 to 5 wt% of an additive that is a surfactant, an antifoaming agent, or a mixture thereof;
and a binder as the remainder, the binder comprising silicone oil or at least one selected from the group consisting of a silanol group, an alkoxysilyl group, and polydimethylsiloxane, in a molecule.

The solvent may be at least one selected from the group consisting of toluene, ethyl alcohol, methyl ethyl ketone (MEK), n-heptane, and isopropyl alcohol (IPA).

The additive may be a surfactant, an antifoaming agent, or a mixture thereof.

In the above description, the surfactant may be at least one selected from the group consisting of sodium alkyl diphenyloxide disulfonate, polyoxyethylene tridecyl ether sulfate, polyalkyleneoxide silane, sodium alkyl diphenyloxide disulfonate, and a fluoric surfactant.

In addition, the antifoaming agent may be at least one selected from the group consisting of silicone, polysiloxane, polymethylsiloxane, modified polysiloxane, and ether-modified polysiloxane.

In another embodiment of the present invention, provided is a method for forming a moisture permeation preventing film for an electronic device, comprising a step of preparing a composition for a moisture permeation preventing film for an electronic device, comprising 1 to 10 wt% of an aerogel that comprises silica, 10 to 50 wt% of a solvent, 0.1 to 5 wt% of an additive that is a surfactant, an antifoaming agent, or a mixture thereof, and a binder as the remainder, the binder comprising silicone oil or at least one selected from the group consisting of a silanol group, an alkoxysilyl group, and polydimethylsiloxane, in a molecule; a step of applying the composition for a moisture permeation preventing film for an electronic device on a substrate; and a step of drying the applied composition for a moisture permeation preventing film for an electronic device on the substrate.

Hereinafter, each step of the method is described.

In the step of applying the composition for a moisture permeation preventing film for an electronic device on a substrate, an application amount of the composition for a moisture permeation preventing film for an electronic device per area (m²) of each side of the substrate may be 135 to 1,227 g/m².

In still another embodiment of the present invention, provided is an electronic device including a substrate; and a moisture permeation preventing film for an electronic device, located on the substrate and including 1 to 10 wt% of an aerogel that comprises silica, 0.1 to 5 wt% of an additive that is a surfactant, an antifoaming agent, or a mixture thereof, and a binder as the remainder, the binder comprising silicone oil or at least one selected from the group consisting of a silanol group, an alkoxysilyl group, and polydimethylsiloxane, in a molecule.

The moisture permeation preventing film for an electronic device is described as follows.

The moisture permeation preventing film for an electronic device may have a thickness in a range of 100 to 900 µm.

The moisture permeation preventing film for an electronic device may be formed as a single layer.

The substrate is described as follows.

The substrate may be a flexible board.

The flexible board may consist of a material selected from the group consisting of polyethylene terephthalate (PET), polyacrylate (PA), polycarbonate (PC), polyethersulfone (PES), polyimide (PI), and a combination thereof.

Independently, the substrate may be a rigid board.

The rigid board may consist of a material selected from glass.

Meanwhile, the electronic device may be a touch panel, a battery, or a display device.

### [Advantageous Effects]

According to embodiments of the present invention, a composition for a moisture permeation preventing film for an electronic device which is capable of lowering moisture permeability by including an aerogel, thereby preventing deterioration of the function of the electronic device, and prolonging the lifespan thereof, a method for forming a moisture permeation preventing film using the same, and an electronic device can be provided.

Furthermore, by securing excellent flexibility of the moisture permeation preventing film, applications for flexible, wearable, and display devices are possible, and the moisture permeation preventing film can be applied in various electronic devices such as touch panel sensors, batteries, and the like.

### [Brief Description of Drawings]

FIG. 1 is an image obtained while evaluating the transparency of a moisture permeation preventing film formed according to Example 1.
FIG. 2 is an image obtained while evaluating the transparency of a moisture permeation preventing film formed according to Example 3.
FIG. 3 is an image obtained while evaluating the transparency of a moisture permeation preventing film formed according to Example 5.
FIG. 4 is an image obtained while evaluating the transparency of a moisture permeation preventing film formed according to Comparative Example 1.
FIGS. 5 and 6 are images obtained while evaluating the flexibility of a moisture permeation preventing film formed according to Example 5.

### [Best Mode]

Hereinafter, embodiments of the present invention will be described in detail. However, as these embodiments are presented as examples, the present invention is not limited thereto, and the present invention is only defined by the scope of the claims to be described below.

As specified in claim 1 the invention provides a composition for a moisture permeation preventing film for an electronic device.

This corresponds to a composition for a moisture permeation preventing film for an electronic device, which, by including an aerogel (specifically, hydrophobic aerogel), is capable of lowering moisture permeability by including an aerogel, thereby preventing deterioration of the function of an electronic device and prolonging the lifespan thereof.

Therefore, excellent flexibility of a moisture permeation preventing film can be secured, applications for flexible and/or wearable display devices are possible, and the moisture permeation preventing film can be advantageously applied in various electronic devices such as touch panel sensors, batteries, and the like.

Hereinafter, the moisture permeation preventing film for an electronic device will be described in detail.

As previously described, the composition for a moisture permeation preventing film for an electronic device includes 1 to 10 wt% of an aerogel; 10 to 50 wt% of a solvent; 0.1 to 5 wt% of an additive; and a binder as the remainder based on a total 100 wt% of the composition for a moisture permeation preventing film for an electronic device, and the reason for limiting the content of each material thereto is described as follows.

### Aerogel: 1 to 10 wt%

When the content of an aerogel in the composition for a moisture permeation preventing film for an electronic device satisfies a range of 1 to 10 wt%, as previously described, there are cases in which moisture permeability of a moisture permeation preventing film can be lowered and flexibility is secured.

However, at above 10 wt%, the viscosity of the composition becomes too high, and as a result, it is difficult to uniformly form a moisture permeation preventing film. Accordingly, a phenomenon in which the transparency and permeability of the formed moisture permeation preventing film are reduced may occur. On the contrary, at below 1 wt%, the content of the aerogel is too low to be expected to be effective.

### Solvent: 10 to 50 wt%

The content of the solvent in the composition for a moisture permeation preventing film for an electronic device satisfying a range of 10 to 50 wt% can result in the viscosity and density in which the binder, the aerogel, and the additive can be properly dispersed.

However, at 50 wt% or above, due to the excessively high content of the solvent, the density of the composition decreases, which is a factor for increased moisture permeability of the moisture permeation preventing film thus formed. In contrast, in the case of below 10 wt%, the viscosity of the composition becomes too high, and as a result, it is difficult for each material to be uniformly dispersed, and the moisture permeation preventing film thus formed may contain bubbles which are difficult to be removed.

### Additive: 0.1 to 5 wt%

Depending on the desired characteristics, the composition for a moisture permeation preventing film for an electronic device may include the additive at 0.1 wt% to 5 wt% therein.

However, at above 5 wt%, the content of the aerogel relatively decreases, and as a result, the moisture permeability of the moisture permeation preventing film thus formed may decrease. In contrast, in the case of below 0.1 wt%, it is difficult for the moisture permeation preventing film to exhibit effectiveness due to the significantly low content thereof.

Hereinafter, each component of the composition for a moisture permeation preventing film for an electronic device provided in one embodiment of the present invention is described in more detail.

First, the aerogel is described as follows.

A hydrophobic aerogel may contribute to significantly lowering the moisture permeability of a moisture permeation preventing film.

More specifically, the aerogel includes silica, and in the examples described below, such silica aerogel is used.

Although the particle diameter of the aerogel is not particularly limited, it is necessary for the diameter to be less than or equal to the thickness of the moisture permeation preventing film to be formed.

The binder is described as follows.

The binder may include silicone oil.

Alternatively, the binder may include at least one selected from the group consisting of a silanol group, an alkoxysilyl group, and polydimethylsiloxane, in a molecule.

The solvent, as previously described, is not particularly limited as long as the solvent is a material capable of dissolving and uniformly dispersing the aerogel, the binder, and the additive.

For example, the solvent may be at least one selected from the group consisting of toluene, ethyl alcohol, methyl ethyl ketone (MEK), n-heptane, and isopropyl alcohol (IPA).

In the cases of the examples described below, ethyl alcohol is used as the solvent.

Meanwhile, the additive is described as follows.

The additive is used to provide various functionalities to the composition for a moisture permeation preventing film for an electronic device or to improve the characteristics of the composition, and the additive may be a surfactant, an antifoaming agent, or a mixture thereof. That is, as the additive, the surfactant may be used alone, the antifoaming agent may be used alone, or a combination of the surfactant and the antifoaming agent may be used.

In the above description, the surfactant may be at least one selected from the group consisting of sodium alkyl diphenyloxide disulfonate, polyoxyethylene tridecyl ether sulfate, polyalkyleneoxide silane, sodium alkyl diphenyloxide disulfonate, and a fluoric surfactant.

That is, the surfactant may be selected as one substance among the listed substances or selected by combining two or more substances. In the examples described below, a fluoric surfactant is used as the surfactant.

In addition, the antifoaming agent may include at least one selected from the group consisting of silicone, polysiloxane, polymethylsiloxane, modified polysiloxane, and ether-modified polysiloxane.

That is, as the antifoaming agent, one substance among the listed substances may be selected or a combination of two or more substances among the listed substances may be selected. In the examples described below, a silicone antifoaming agent is used as the antifoaming agent.

In another embodiment of the present invention, provided is a method for forming a moisture permeation preventing film for an electronic device, comprising a step of preparing a composition for a moisture permeation preventing film for an electronic device, comprising 1 to 10 wt% of an aerogel that comprises silica, 10 to 50 wt% of a solvent, 0.1 to 5 wt% of an additive that is a surfactant, an antifoaming agent, or a mixture thereof, and a binder as the remainder, the binder comprising silicone oil or at least one selected from the group consisting of a silanol group, an alkoxysilyl group, and polydimethylsiloxane, in a molecule; a step of applying the composition for a moisture permeation preventing film for an electronic device on a substrate; and a step of drying the applied composition for a moisture permeation preventing film for an electronic device on the substrate.

Specifically, the moisture permeation preventing film for an electronic device may be identical to what was previously described. In this case, a method for forming a moisture permeation preventing film for an electronic device may be carried out as a simple process of preparing a composition by mixing the raw materials, applying the same on a substrate followed by drying, and the moisture permeation preventing film for an electronic device thus formed may have significant effects which are previously described.

Hereinafter, repeated descriptions are omitted, and each step is described as follows.

In the step of applying the composition for a moisture permeation preventing film for an electronic device on a substrate, an application amount of the composition for a moisture permeation preventing film for an electronic device per area (m²) of each side of the substrate may be in a range of 135 to 1,227 g/m².

When the application amount satisfies the above range, the thickness of the finally formed moisture permeation preventing film may be 100 to 900 µm, and this is the range of thickness which can secure flexibility as well as realize an excellent effect of preventing moisture permeation.

On the other hand, when the application amount of the composition of a moisture permeation preventing film for an electronic device per area (m²) of each side of the substrate is less than 135 g/m², the moisture permeation preventing film is formed with a small thickness of less than 100 µm, and as a result, the effectiveness of a moisture permeation preventing film may be insignificant. In addition, when the application amount of the composition of a moisture permeation preventing film for an electronic device per area of each side of the substrate is greater than 1,227 g/m², the moisture permeation preventing film is formed with an excessively large thickness exceeding 900 µm, and as a result, flexibility and permeability of a moisture permeation preventing film cannot be secured.

Meanwhile, the step of drying the applied composition for a moisture permeation preventing film for an electronic device on the substrate may be carried out at a temperature in a range of 80 to 140 °C for 1 to 3 hours, and in this process, the solvent in the composition of a moisture permeation preventing film for an electronic device applied on the substrate is removed, and a moisture permeation preventing film consisting of the remaining components can be formed.

In still another embodiment of the present invention, provided is an electronic device including a substrate; and a moisture permeation preventing film for an electronic device, located on the substrate and comprising 1 to 10 wt% of an aerogel that comprises silica, 0.1 to 5 wt% of an additive that is a surfactant, an antifoaming agent, or a mixture thereof, and a binder as the remainder, the binder comprising silicone oil or at least one selected from the group consisting of a silanol group, an alkoxysilyl group, and polydimethylsiloxane, in a molecule.

Specifically, the moisture permeation preventing film for an electronic device may be formed by using the previously described method for forming a moisture permeation preventing film for an electronic device and the previously described composition of a moisture permeation preventing film for an electronic device.

Hereinafter, repeated descriptions are omitted, and each component of the electronic device is described as follows.

The moisture permeation preventing film for an electronic device is described as follows.

The thickness of the moisture permeation preventing film for an electronic device may be 100 to 900 µm, but is not particularly limited thereto. As previously described, at below 100 µm, the thickness thereof is too small, thereby it is difficult to expect an effect of preventing moisture permeation, and at above 900 µm, the thickness thereof is too large and may affect flexibility.

The moisture permeation preventing film for an electronic device may be formed as a single layer. Specifically, although formed as a single layer instead of a multilayer structure, the moisture permeation preventing film for an electronic device which satisfies the composition as defined above may manifest an excellent function of preventing moisture permeation. Furthermore, as previously described, a moisture permeation preventing film formed as a multilayer structure has insufficient flexibility, but the moisture permeation preventing film formed as a single layer may have excellent flexibility.

The substrate is described as follows.

The substrate may be a flexible board. In this case, applications for flexible and/or wearable and display devices are possible.

The flexible board, which is not particularly limited as long as it is a material with flexibility, may consist of a material selected from the group consisting of polyethylene terephthalate (PET), polyacrylate (PA), polycarbonate (PC), polyethersulfone (PES), polyimide (PI), and a combination thereof.

Independently, the substrate may be a rigid board. This refers to a board which is commonly used today.

The rigid board, which is not particularly limited as long as it consists of a material without flexibility, may consist of a material selected from glass.

Meanwhile, the electronic device may be a touch panel, a battery or a display device, and examples of the display device include a liquid crystal display (LCD), a light emitting diode (LED), an organic light-emitting diode (OLED), and the like. As such, application to various electronic devices is possible.

### [Implementations]

Hereinafter, the examples of the present invention and the experimental examples therefor are described below. However, the following examples are merely preferred examples of the present invention, and the present invention is not limited to the following examples.

### Examples 1 to 5

First, compositions of a moisture permeation preventing film for an electronic device were prepared by mixing raw materials according to compositions as shown in Table 1 below.

Specifically, for the raw materials, silicone oil (Manufacturer: Shinetsu) was used as a binder, a silica aerogel (Manufacturer: JIOS AEROGEL) was used as an aerogel, ethyl alcohol (Manufacturer: Daejung Chemicals & Metals) was used as a solvent, a silicone antifoaming agent (Manufacturer: AIR PRODUCTS) was used as an antifoaming agent, and a fluoric surfactant (Manufacturer: Momentive) was used as a surfactant.

Afterwards, the prepared composition of a moisture permeation preventing film for an electronic device was applied on a substrate and dried for 2 hours in a dry oven in which the temperature was adjusted to be at 110 °C, in order to form each moisture permeation preventing film having a thickness of 500 µm.

At this time, depending on evaluation type, for the substrate, a commercially available PET film, which is a type of flexible board, having a width of 5 cm, a length of 5 cm, and a thickness of 100 µm was used, or commercially available glass, which is a type of rigid board, was used by cutting the same to a width of 10 cm, a length of 10 cm, and a thickness of 3 mm.

In addition, the application amount per area of each side of the substrate was 520 g/m², and the thickness of the moisture permeation preventing film thus formed was 500 µm. However, in the case of the evaluation of transparency as described below, a moisture permeation preventing film was formed only on a half of a face of the substrate to compare a part on which a moisture permeation preventing film was formed and a part on which a moisture permeation preventing film was not formed for evaluation.

### Comparative Example 1

As shown in Table 1 below, a moisture permeation preventing film was formed on a substrate in the same manner as in Examples 1 to 5, except that only a binder was used.

**Table 1**

| Classification | Binder | Solvent | Aerogel | Surfactant | Antifoaming agent |
|---|---|---|---|---|---|
| Comparative Example 1 | 100 | | - | - | - |
| Example 1 | 87.5 | 10 | 1 | 1 | 0.5 |
| Example 2 | 85.5 | | 3 | 1 | 0.5 |
| Example 3 | 83.5 | | 5 | 1 | 0.5 |
| Example 4 | 81.5 | | 7 | 1 | 0.5 |
| Example 5 | 78.5 | | 10 | 1 | 0.5 |

| | | | | | |
|---|---|---|---|---|---|
| Note: In the above table, the content of each material was indicated as wt% based on a total 100 wt% of the composition. | | | | | |

### Evaluation Example: Evaluation of physical properties of moisture permeation preventing film

Each moisture permeation preventing film formed in Examples 1 to 5 and Comparative Example 1 was evaluated for transparency, flexibility, light transmittance (%), and moisture permeability (g/m²·day), and the result is shown in Table 2 below.

**Table 2**

| Classification | Transparency | Flexibility | Light transmittance (%) | Moisture permeability (g/m²·day) |
|---|---|---|---|---|
| Comparative Example 1 | High | High | 95.8 | 14.4 |
| Example 1 | High | High | 91.3 | 14.08 |
| Example 2 | High | High | 90.4 | 12.95 |
| Example 3 | High | High | 90.9 | 11.22 |
| Example 4 | Medium | High | 88.4 | 11.09 |
| Example 5 | Medium | High | 84.5 | 9.75 |

Specifically, the conditions for each evaluation are as follows.

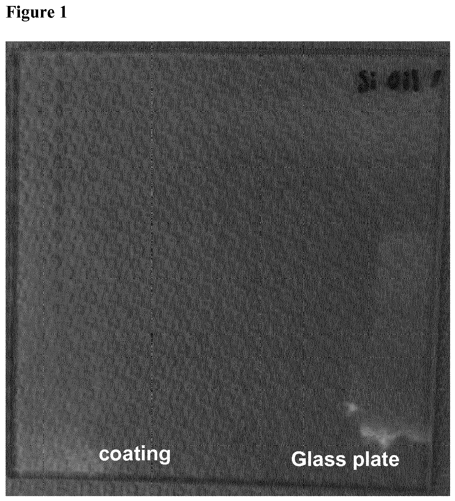

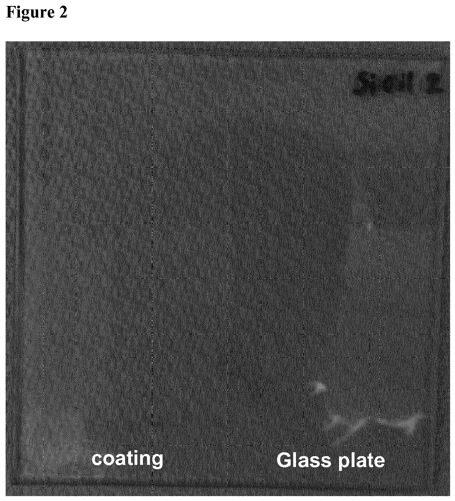

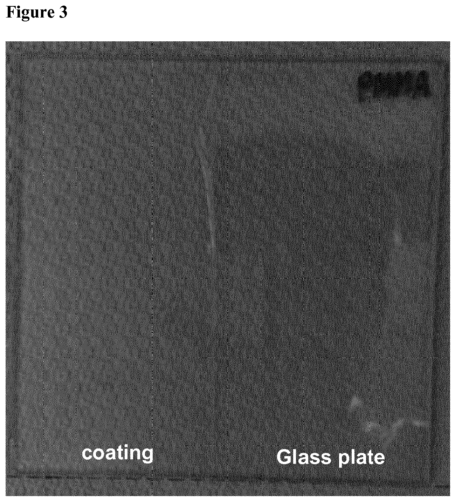

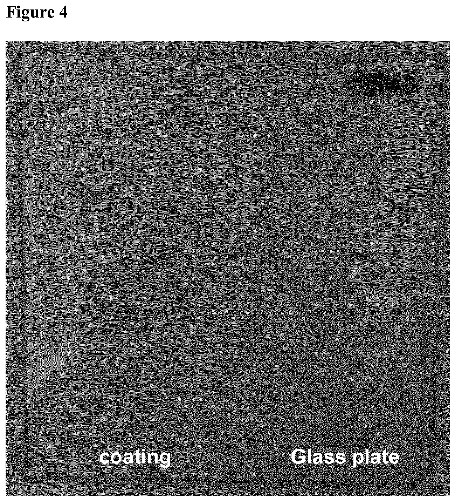

Transparency evaluation: When glass was used as a substrate, the degree to how well the background on the rear face is visible was rated as high, medium, or low. In particular, images obtained while evaluating the transparency for Examples, 1, 3, and 5, and Comparative Example 1 are shown in FIGS. 1, 2, 3, and 4, respectively.

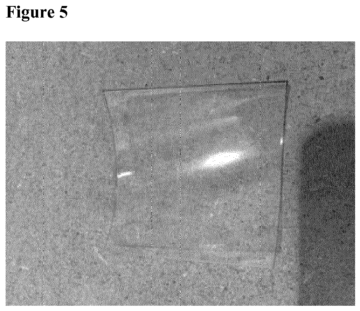

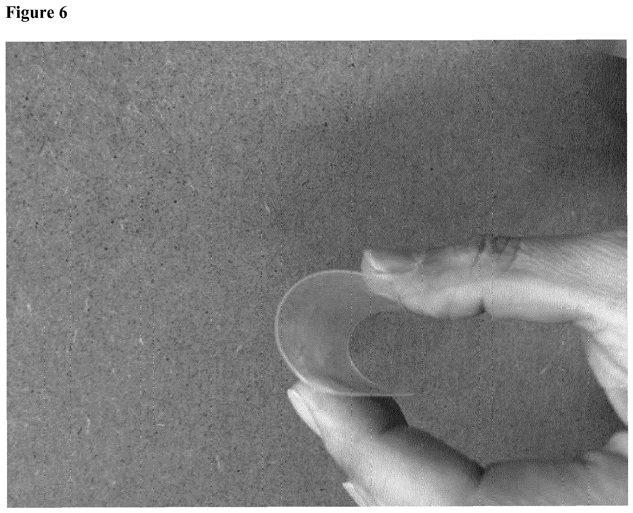

Flexibility evaluation: When a PET film was used as a substrate, the degree to which damage occurred on surface or whether the moisture permeation film was separated, when bending at 90° or more was rated as high, medium, or low. In particular, images obtained when evaluating the flexibility according to Example 5 are shown in FIGS. 5 and 6.

Light transmittance (%) evaluation: When a PET film was used as a substrate, light transmittance was measured by using a color-difference meter.

Moisture permeability evaluation: When a PET film was used as a substrate, moisture permeation was evaluated by ASTM F1249 standards and corresponding equipment.

Through such evaluation results, in Examples 1 to 5 where the composition including a silica aerogel and additives as well as a binder was applied as a moisture permeation preventing film, similar flexibility compared to Comparative Example 1, where only a binder was applied as a moisture permeation preventing film, was secured, and also transparency and light transmittance were reduced. In particular, it was found that moisture permeability which is a characteristic essentially required to be low in moisture permeation preventing films was significantly reduced.

## Claims

1. A composition for a moisture permeation preventing film for an electronic device, comprising:
1 to 10 wt% of an aerogel that comprises silica;
10 to 50 wt% of a solvent;
0.1 to 5 wt% of an additive that is a surfactant, an antifoaming agent, or a mixture thereof; and
a binder as the remainder, the binder comprising silicone oil or at least one selected from the group consisting of a silanol group, an alkoxysilyl group, and polydimethylsiloxane, in a molecule.

2. The composition of claim 1, wherein the solvent is at least one selected from the group consisting of toluene, ethyl alcohol, methyl ethyl ketone (MEK), n-heptane, and isopropyl alcohol (IPA).

3. The composition of claim 1, wherein the surfactant is at least one selected from the group consisting of sodium alkyl diphenyloxide disulfonate, polyoxyethylene tridecyl ether sulfate, polyalkyleneoxide silane, sodium alkyl diphenyloxide disulfonate, and a fluoric surfactant or the antifoaming agent is at least one selected from the group consisting of silicone, polysiloxane, polymethylsiloxane, modified polysiloxane, and ether-modified polysiloxane.

4. A method for forming a moisture permeation preventing film for an electronic device, comprising:
a step of preparing a composition for a moisture permeation preventing film for an electronic device, comprising 1 to 10 wt% of an aerogel that comprises silica, 10 to 50 wt% of a solvent, 0.1 to 5 wt% of an additive that is a surfactant, an antifoaming agent, or a mixture thereof, and a binder as the remainder, the binder comprising silicone oil or at least one selected from the group consisting of a silanol group, an alkoxysilyl group, and polydimethylsiloxane, in a molecule;
a step of applying the composition for a moisture permeation preventing film for an electronic device on a substrate; and
a step of drying the composition for a moisture permeation preventing film for an electronic device that has been applied on the substrate.

5. The method of claim 4, wherein, in the step of applying the composition for a moisture permeation preventing film for an electronic device on a substrate, an application amount of the composition for a moisture permeation preventing film for an electronic device per area (m²) of each side of the substrate is 135 to 1,227 g/m².

6. An electronic device comprising:
a substrate; and
a moisture permeation preventing film for an electronic device located on the substrate and, comprising 1 to 10 wt% of an aerogel that comprises silica, 0.1 to 5 wt% of an additive that is a surfactant, an antifoaming agent, or a mixture thereof, and a binder as the remainder, the binder comprising silicone oil or at least one selected from the group consisting of a silanol group, an alkoxysilyl group, and polydimethylsiloxane, in a molecule.

7. The electronic device of claim 6, wherein the moisture permeation preventing film for an electronic device has a thickness in a range of 100 to 900 µm.

8. The electronic device of claim 6, wherein the moisture permeation preventing film for an electronic device is formed as a single layer.

9. The electronic device of claim 6, wherein the substrate is a flexible board.

10. The electronic device of claim 9, wherein the flexible board consists of a material selected from the group consisting of polyethylene terephthalate (PET), polyacrylate (PA), polycarbonate (PC), polyethersulfone (PES), polyimide (PI), and a combination thereof.

11. The electronic device of claim 6, wherein the substrate is a rigid board including glass.

12. The electronic device of claim 6, wherein the electronic device is a touch panel, a battery, or a display device.

## Patentansprüche

1. Zusammensetzung für einen Feuchtigkeitspermeationsverhinderungsfilm für eine elektronische Vorrichtung, umfassend:
zu 1 bis 10 Gew.-% ein Aerogel, das Siliciumdioxid umfasst;
zu 10 bis 50 Gew.-% ein Lösungsmittel;
zu 0,1 bis 5 Gew.-% ein Additiv, das ein Tensid, ein Antischaummittel oder eine Mischung davon ist; und
ein Bindemittel als der Rest, das Bindemittel umfassend Silikonöl oder mindestens eines ausgewählt aus der Gruppe bestehend aus einer Silanolgruppe, einer Alkoxysilylgruppe und Polydimethylsiloxan in einem Molekül.

2. Zusammensetzung nach Anspruch 1, wobei das Lösungsmittel mindestens eines ist, das ausgewählt ist aus der Gruppe bestehend aus Toluol, Ethylalkohol, Methylethylketon (MEK), n-Heptan und Isopropylalkohol (IPA).

3. Zusammensetzung nach Anspruch 1, wobei das Tensid mindestens eines ist, das ausgewählt ist aus der Gruppe bestehend aus Natriumalkyldiphenyloxiddisulfonat, Polyoxyethylentridecylethersulfat, Polyalkylenoxidsilan, Natriumalkyldiphenyloxiddisulfonat und einem Fluortensid, oder das Antischaummittel mindestens eines ist, das ausgewählt ist aus der Gruppe bestehend aus Silikon, Polysiloxan, Polymethylsiloxan, modifiziertem Polysiloxan und ethermodifiziertem Polysiloxan.

4. Verfahren zum Ausbilden eines Feuchtigkeitspermeationsverhinderungsfilms für eine elektronische Vorrichtung, umfassend:
einen Schritt eines Herstellens einer Zusammensetzung für einen Feuchtigkeitspermeationsverhinderungsfilm für eine elektronische Vorrichtung, umfassend zu 1 bis 10 Gew.-% ein Aerogel, das Siliciumdioxid umfasst, zu 10 bis 50 Gew.-% ein Lösungsmittel, zu 0,1 bis 5 Gew.-% ein Additiv, das ein Tensid, ein Antischaummittel oder eine Mischung davon ist, und ein Bindemittel als der Rest, das Bindemittel umfassend Silikonöl oder mindestens eines ausgewählt aus der Gruppe bestehend aus einer Silanolgruppe, einer Alkoxysilylgruppe und Polydimethylsiloxan in einem Molekül;
einen Schritt eines Aufbringens der Zusammensetzung für einen Feuchtigkeitspermeationsverhinderungsfilm für eine elektronische Vorrichtung auf einem Substrat; und
einen Schritt eines Trocknens der Zusammensetzung für einen Feuchtigkeitspermeationsverhinderungsfilm für eine elektronische Vorrichtung, die auf das Substrat aufgebracht wurde.

5. Verfahren nach Anspruch 4, wobei in dem Schritt des Auftragens der Zusammensetzung für einen Feuchtigkeitspermeationsverhinderungsfilm für eine elektronische Vorrichtung auf ein Substrat eine Auftragungsmenge der Zusammensetzung für einen Feuchtigkeitspermeationsverhinderungsfilm für eine elektronische Vorrichtung pro Fläche (m²) auf jeder Seite des Substrats 135 bis 1.227 g/m² beträgt.

6. Elektronische Vorrichtung, umfassend:
ein Substrat; und
einen Feuchtigkeitspermeationsverhinderungsfilm für eine elektronische Vorrichtung, der sich auf dem Substrat befindet und umfassend zu 1 bis 10 Gew.-% ein Aerogel, das Siliciumdioxid umfasst, zu 0,1 bis 5 Gew.-% ein Additiv, das ein Tensid, ein Antischaummittel oder eine Mischung davon ist, und ein Bindemittel als der Rest, das Bindemittel umfassend Silikonöl oder mindestens eines ausgewählt aus der Gruppe bestehend aus einer Silanolgruppe, einer Alkoxysilylgruppe und Polydimethylsiloxan in einem Molekül.

7. Elektronische Vorrichtung nach Anspruch 6, wobei der Feuchtigkeitspermeationsverhinderungsfilm für eine elektronische Vorrichtung eine Dicke in einem Bereich von 100 bis 900 µm aufweist.

8. Elektronische Vorrichtung nach Anspruch 6, wobei der Feuchtigkeitspermeationsverhinderungsfilm für eine elektronische Vorrichtung als eine einzige Schicht ausgebildet ist.

9. Elektronische Vorrichtung nach Anspruch 6, wobei das Substrat eine flexible Platte ist.

10. Elektronische Vorrichtung nach Anspruch 9, wobei die flexible Platte aus einem Material besteht, das ausgewählt ist aus der Gruppe bestehend aus Polyethylenterephthalat (PET), Polyacrylat (PA), Polycarbonat (PC), Polyethersulfon (PES), Polyimid (PI) und einer Kombination davon.

11. Elektronische Vorrichtung nach Anspruch 6, wobei das Substrat eine starre Platte ist, die Glas einschließt.

12. Elektronische Vorrichtung nach Anspruch 6, wobei die elektronische Vorrichtung ein Berührungsfeld, eine Batterie oder eine Anzeigevorrichtung ist.

## Revendications

1. Composition pour film de protection contre l'imprégnation de l'humidité pour un dispositif électronique, comprenant :
1 à 10 % en poids d'un aérogel qui comprend de la silice ;
10 à 50 % en poids d'un solvant ;
0,1 à 5 % en poids d'un additif qui est un tensioactif, un agent antimousse ou un mélange de ceux-ci ; et
un liant pour le reste, le liant comprenant une huile de silicone ou au moins un élément choisi dans le groupe constitué d'un groupe silanol, d'un groupe alcoxysilyle et d'un polydiméthylsiloxane, dans une molécule.

2. Composition selon la revendication 1, dans laquelle le solvant est au moins un solvant choisi dans le groupe constitué du toluène, alcool éthylique, méthyl-éthyl-cétone (MEC), n-heptane et alcool isopropylique (IPA).

3. Composition selon la revendication 1, dans laquelle le tensioactif est au moins un tensioactif choisi dans le groupe constitué par le disulfonate d'alkyldiphényloxyde de sodium, le sulfate d'éther tridécylique de polyoxyéthylène, le silane d'oxyde de polyalkylène, le disulfonate d'oxyde de diphényloxyde d'alkyle de sodium et un tensioactif fluoré ou l'agent antimousse est au moins un tensioactif choisi dans le groupe constitué par la silicone, polysiloxane, polyméthylsiloxane, polysiloxane modifié et polysiloxane modifié par un éther.

4. Procédé de formation d'un film de protection contre l'imprégnation de l'humidité pour un dispositif électronique, comprenant :
une étape de préparation d'une composition pour un film de protection contre l'imprégnation de l'humidité pour un dispositif électronique, comprenant de 1 à 10 % en poids d'un aérogel qui comprend de la silice, de 10 à 50 % en poids d'un solvant, de 0,1 à 5 % en poids d'un additif qui est un tensioactif, un agent antimousse, ou un mélange de ceux-ci, et un liant pour le reste, le liant comprenant de l'huile de silicone ou au moins un élément choisi dans le groupe constitué d'un groupe silanol, un groupe alcoxysilyle et d'un polydiméthylsiloxane, dans une molécule ;
une étape d'application de la composition pour un film de protection contre l'imprégnation de l'humidité pour un dispositif électronique sur un substrat ; et
une étape de séchage de la composition pour un film de protection contre l'imprégnation de l'humidité pour un dispositif électronique qui a été appliqué sur le substrat.

5. Procédé selon la revendication 4, dans lequel, dans l'étape d'application de la composition pour un film de protection contre l'imprégnation de l'humidité pour un dispositif électronique sur un substrat, une quantité d'application de la composition pour un film de protection contre l'imprégnation de l'humidité pour un dispositif électronique par surface (m²) de chaque côté du substrat va de 135 à 1 227 g/m².

6. Dispositif électronique comprenant :
un substrat ; et
un film de protection contre l'imprégnation de l'humidité pour un dispositif électronique situé sur le substrat et, comprenant de 1 à 10 % en poids d'un aérogel qui comprend de la silice, de 0,1 à 5 % en poids d'un additif qui est un tensioactif, un agent antimousse, ou un mélange de ceux-ci, et un liant pour le reste, le liant comprenant une huile de silicone ou au moins un élément choisi dans le groupe constitué d'un groupe silanol, d'un groupe alcoxysilyle et d'un polydiméthylsiloxane, dans une molécule.

7. Dispositif électronique selon la revendication 6, dans lequel le film de protection contre l'imprégnation de l'humidité pour un dispositif électronique a une épaisseur se situant dans une plage de 100 à 900 µm.

8. Dispositif électronique selon la revendication 6, dans lequel le film de protection contre l'imprégnation de l'humidité pour un dispositif électronique est formé en une seule couche.

9. Dispositif électronique selon la revendication 6, dans lequel le substrat est une carte souple.

10. Dispositif électronique selon la revendication 9, dans lequel la carte souple est constituée d'un matériau choisi dans le groupe constitué de polyéthylène téréphtalate (PET), polyacrylate (PA), polycarbonate (PC), polyéthersulfone (PES), polyimide (PI) et d'une combinaison de ceux-ci.

11. Dispositif électronique selon la revendication 6, dans lequel le substrat est une carte rigide comportant du verre.

12. Dispositif électronique selon la revendication 6, dans lequel le dispositif électronique est un panneau tactile, une batterie ou un dispositif d'affichage.
